# EUROPEAN PATENT SPECIFICATION

(11) **EP 0 860 101 B1**
(45) Date of publication and mention of the grant of the patent: **20.10.2004**
(21) Application number: 96938583.0
(22) Date of filing: 06.11.1996
(51) Int. Cl.: H05K 3/22, G01R 1/073, G01R 31/28

(54) **METHOD FOR PRODUCING CONTACT PADS ON ADAPTER BOARDS AND ADAPTER BOARD FOR TESTING PATTERN BOARDS**
VERFAHREN ZUR HERSTELLUNG VON KONTAKTLÖCHERN AUF ADAPTERPLATTEN UND ADAPTERPLATTE ZUR PRÜFUNG VON MUSTERPLATTEN
PROCEDE DE PRODUCTION DE PLAGES DE CONTACT SUR DES PLAQUETTES D'ADAPTATION ET PLAQUETTES D'ADAPTATION POUR L'ESSAI DES PLAQUETTES A MOTIFS

(30) Priority: 06.11.1995 SE 9503893
(43) Date of publication of application: 26.08.1998
(73) Proprietor: Strandberg, Reinhold, 818 92 Valbo (SE)
(72) Inventor: Strandberg, Reinhold, 818 92 Valbo (SE)
(74) Representative: Olsson, Jan
(86) International application number: PCT/SE1996/001424
(87) International publication number: WO 1997/017822

(56) References cited:
- EP-A- 0 646 800
- WO-A-89/05088
- WO-A-90/12323
- WO-A-94/04015
- US-A- 5 134 363

## Description

### FIELD OF THE INVENTION AND PRIOR ART

This invention is related to a method for producing contact pads on pattern boards, comprising a plating treatment in order to apply electrically conducting material on the board in correspondence to the desired contact pads.

It is preferred that the pattern board in question is formed by an adapter board intended to be used in an apparatus for testing pattern boards provided with electrically conducting paths. For this purpose, the adapter board comprises, on a first side, first electrically conducting places, which are located in correspondence to electrically conducting places on the pattern board to be tested and arranged to be caused to contact these places by means of a conducting mat. On its second side, the adapter board comprises second electrically conducting places intended to contact test-contact spots of the test apparatus. Test signals are applied via these test-contact spots for the purpose of testing whether the conducting paths of the pattern board to be tested fulfil specified requirements.

Adapter boards are known from documents US-A-5134363 and WO-A-9012323.

Pattern boards to be tested are as a rule coated with a protective film except on those electrically conducting places which are to be used for connection purposes. These electrically conducting places have the character of contact pads, the external surface of which normally is countersunk relative to the surrounding protective film. The contact pads of the adapter board have, according to prior art, been designed with flat external contact surfaces substantially parallel to the plane of the adapter board, said contact surfaces being peripherically termiinated by a sharp edge. In order to establish an acceptable electrical contact between the pattern board to be tested and the adapter board, these are pressed together with the conducting mat placed therebetween. Since the contact pads on the pattern board to be tested are somewhat retracted in relation to the surrounding protective film, the conducting mat must be pressed into the cavities at the contact pads by means of the contact pads of the adapter board. This means that the contact pads of the adapter board will be pressed into the conducting mat and cause cutting thereof or in any case a substantial wear thereon.

It has been proposed to apply tin on the contact pads of the adapter board for the purpose of making them less susceptible of acting in a wearing/cutting manner on the conducting mat. However, those proposals have not led to an acceptable result. One of the reasons therefor is presumably that capillary force results in different tin height on small and large contact pads, a fact which creates irregularity as far as the contact over the area of the adapter board and the test result are concerned.

### SUMMARY OF THE INVENTION

The object of the present invention is to devise routes to reduce the problems discussed herein above with regard to the prior art and, accordingly, to devise a rational route to produce the adapter board so that the contact pads thereof to a smaller degree act destructingly on the conducting mat.

In order to fulfil this object, the invention provides a method for producing contact pads according to claim 1 and an adapter board design more specifically appearing from claim 5.

With regard to the method according to claim 1, the object is achieved by the electrically conducting material at the contact pads being subjected to a treatment with an agent capable of etching the material in order to provide chamfering or rounding of peripherical edges of the contact pads. This chamfering or rounding reduces substantially the tendency to wear/cutting of the material of the conducting mat and gives rise to, as a rule, a smaller need of power for pressing the pattern board to be tested and the adapter board against each other by reduction of the need for deformation of the conducting mat when testing is to be carried out.

Since the chamfering or rounding of the contact pads according to the invention is carried out by etching, a very rational production method may be resorted to.

Furthermore, it should be noted that the chamfering or rounding according to the invention by means of etching does not interfere with uniform thickness of the contact pads perpendicularly to the plane of the adapter board. Thus, the etching does not give rise to different height of the contact pads as a consequence of the area thereof projected onto the adapter board.

Further features of the invention appear from the dependent claims.

Further advantages and features of the invention appear from the following description.

### BRIEF DESCRIPTION OF THE DRAWINGS

With reference to the enclosed drawings, a more specific description of embodiment examples of the invention will follow hereinafter.

In the drawings:
- Fig 1: is a very diagrammatical view illustrating parts of a testing apparatus for pattern boards;
- Fig 2: is a view illustrating a base plate for a pattern board forming an adapter plate provided with holes at such places, where electrical connections are required through the adapter board;
- Fig 3: is a view of a part of the adapter board during a first plating step;
- Fig 4: is a view similar to Fig 3 but illustrating a second plating step;
- Fig 5: is a view taken along the line V-V in Fig 4;
- Fig 6: is a view similar to Fig 4 but with protective masks removed;
- Fig 7: is a view taken along the line VII-VII in Fig 6;
- Fig 8: is a view illustrating how the final etching treatment has resulted in a chamfering or rounding of the peripherical edges of the contact pads;
- Fig 9: is a view taken along the line IX-IX in Fig 8;
- Fig 10-16: are views illustrating the different steps in the production of an adapter board in a manner which differs somewhat compared to the previous embodiment; and
- Fig 17: is a diagrammatical view illustrating an alternative embodiment of contact pads on the adapter board.

### DETAILED DESCRIPTION OF PREFERRED EMBODIMENTS

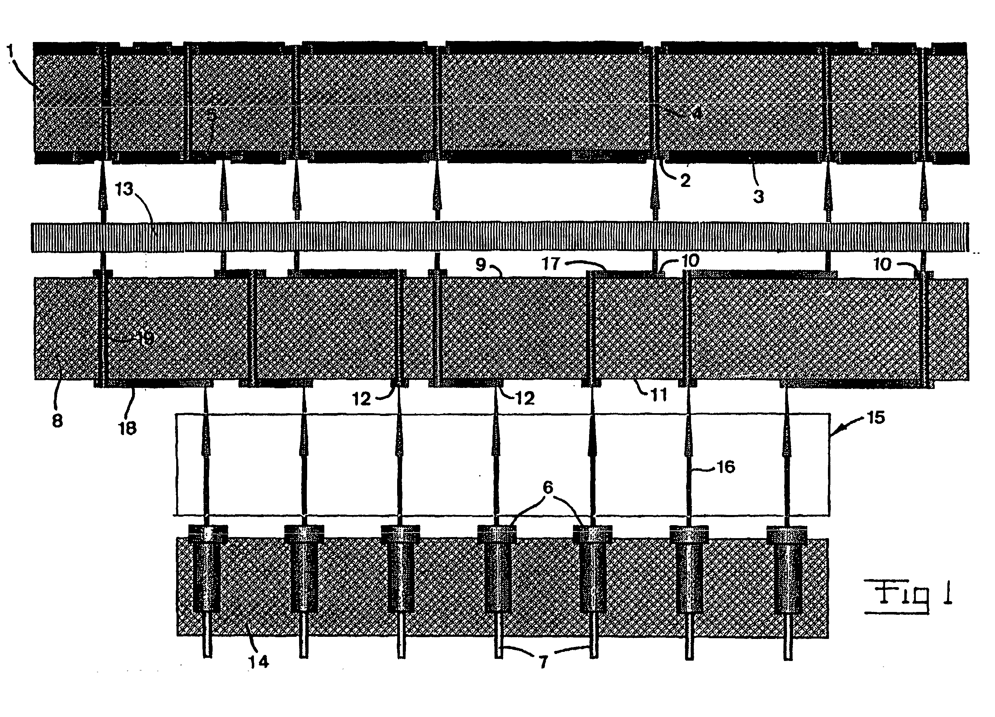

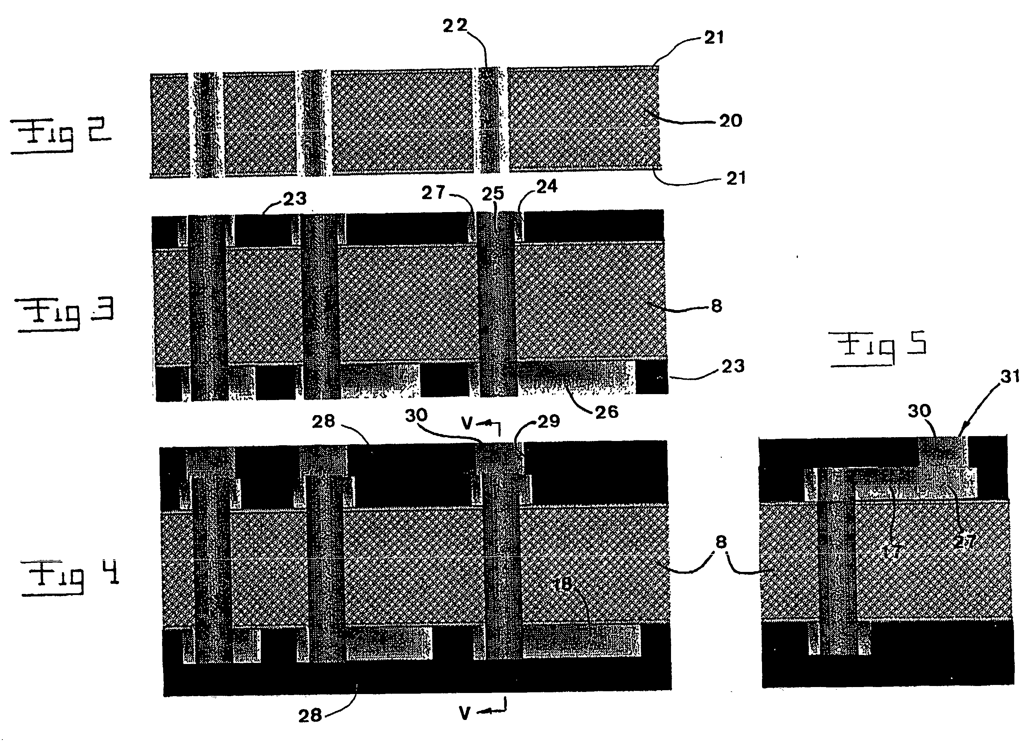

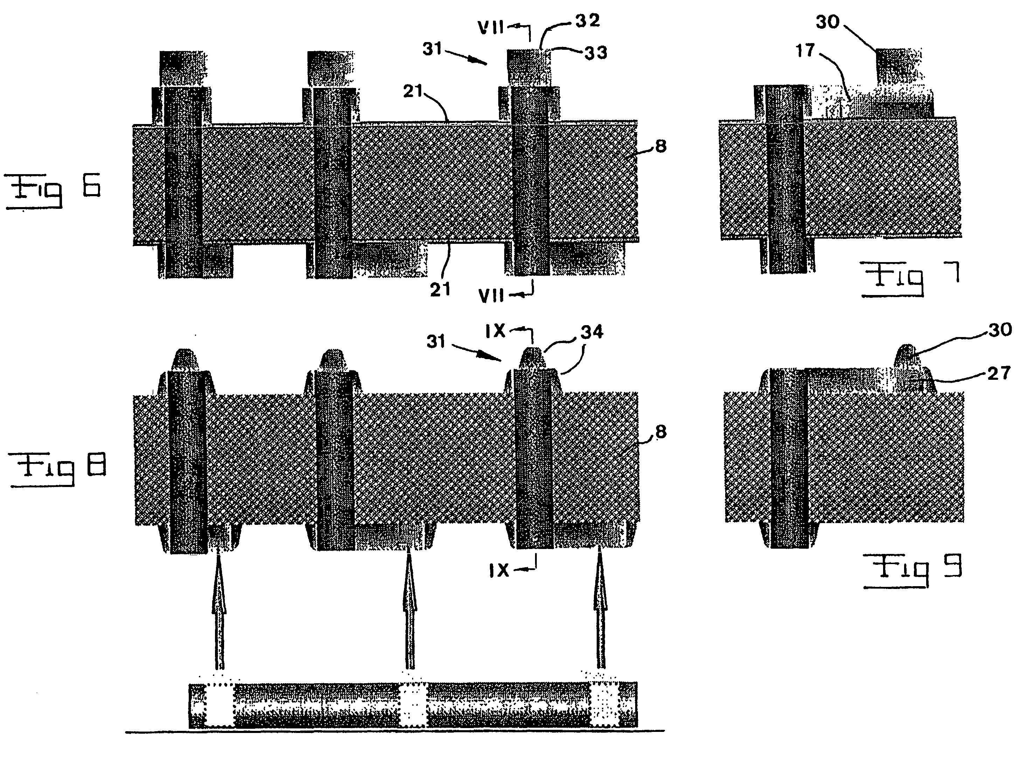

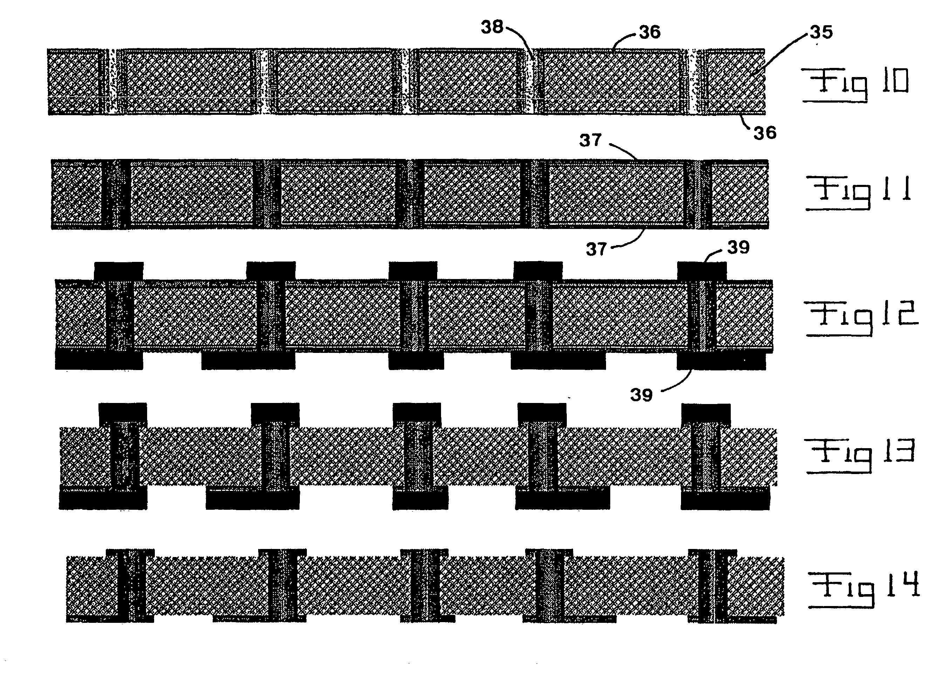

A pattern board to be tested is denoted 1 in Fig 1. This pattern board comprises electrically conducting places 2 in the form of contact pads. With exception of these contact pads, the pattern board 1 is coated by means of a protective film 3. The contact pads 2 are at times connected to corresponding contact pads on the opposite side of the pattern board 1 via holes 4, which normally are obtained by boring, and electrically conducting plating provided on the hole wall.

As appears from Fig 1, the contact pads 2 may occur in immediate connection to the plated holes 4, but they may also be located displaced sidewardly therefrom by means of a conducting path provided on the pattern board 1 as indicated at 5.

The external surface of the protective film 3 is normally located externally of the outer surface of the contact pad 2 so that the latter becomes countersunk relative to the external surface of the protective film.

An apparatus for testing circuit boards comprises a set of test-contact spots 6. These are arranged in a certain distribution and comprises terminals 7, via which test signals for testing of the conducting paths of the pattern board 1 are applicable. The distribution of the test-contact spots 6 is normally regular so that they are situated in a screen pattern. The distance between adjacent test-contact spots may for instance amount to 2.54 mm.

The test apparatus comprises an adapter board 8 prepared specifically for the special pattern board 1 to be tested. This adapter board 8 comprises, on a first side 9, first electrically conducting places 10 in the form of contact pads, which are located in correspondence to the contact pads 2 on the pattern board 1 to be tested. On its second 11, the adapter board 8 comprises second electrically conducting places 12 in the form of contact pads intended to contact the test-contact spots 6 of the test apparatus.

In order to establish electrically conducting contact between the contact pads 10 of the adapter board 8 and the contact pads 2 of the pattern board 1, a conducting mat 13 is placed between them. This mat is at least somewhat flexible and formable so that it may, on pressing of the pattern board 1 and the adapter board 8 towards each other, adjust to the topography of the boards to at least some extent. The mat 13 may for instance consist of a natural or synthetic rubber material. In this connection it is pointed out that also various different types of plastics are comprised within the scope of this expression as long as they present the properties required. Furthermore, the mat 13 is provided with electrically conducting constituents in order to impart the mat electrical conductivity to a degree required for carrying out the testing.

The test apparatus may be designed so that the test-contact spots 6 are adapted to enter into a direct contact with the contact pads 12 of the adapter board 8. In order to achieve a good contact, it is preferred that resilience is provided. In the example illustrated in Fig 1, the test-contact spots 6 are, however, intended to be received in a bed or plate 14 belonging to the test apparatus without resilience. In such a case a further adapter generally denoted 15 may be arranged between the test-contact spots 6 and the adapter board 8. This additional adapter is only diagrammatically indicated in Fig 1 but may suitably comprise contact members 16 adapted to establish a contact between the test-contact spots 6 and the contact pads 12 of the adapter board 8. The contact members 16 are, in the example, conceived to consist of contact pins, suitably such pins, the length of which is reducable by overcoming a spring force. When the adapter board 8 is pressed downwardly towards the bed 14, the contact pins 16 contained in the adapter 15 will be able to resiliently yield to a certain extent while establishing an electrical contact between the test-contact spots 6 and the contact pads 12.

It is pointed out that it would be possible to replace the adapter 15 described based upon the use of contact pins 16 by means of an electrically conducting mat similar to the one discussed hereinabove and denoted 13.

When the pattern board 1 is tested, it is pressed downwardly towards the bed or plate by means of a pressure cushion located above the board. It should be understood that the test apparatus, if so desired, may be provided with an additional set of adapter board etc located above the pattern board 1 to be tested so that also the upper side of the pattern board 1, and then preferably in one and the same fastening in the test apparatus, may be subjected to testing as far as the conducting pattern on the upper side is concerned.

In Fig 1, guide members in the form of pins, holes etc for a mutual guiding of the pattern board 1, the adapter board 8 and the bed 14 have been left out, although such guide members in practice are indispensable for achieving the required precision.

As far as the design of such guide members is concerned, reference is, however, made to my SE-patent 458 005.

The adapter board 8 comprises, between its contact pads 10, 12 located on opposite sides 9, 11, conducting paths 17 and 18 respectively located on the respective sides of the board and connections 19 coupling them together in the form of a plating of an electrically conducting material located on a hole wall.

The production of the adapter board 8 will now be described more closely in the following. In Fig 2, it is illustrated that the starting material is formed by a sheet 20 of an electrically insulating material. This sheet is, on its two flat sides, provided with a layer 21 of a conducting material. It may, for instance, be copper to a thickness of 5 µm. This plate is bored so as to obtain holes 22 in correspondence to the pattern board to be tested by means of the adapter board.

Protective masks 23 are next provided on the sides of the pattern board. These protective masks leave openings at such places 24 where metal is to be plated. It appears from Fig 3 that plating, for instance by means of copper, has been carried out such that there has been applied, on the walls of the hole 22, a connecting plating 25 in substantially cylindrical shape and extending between the contact pads 26 on the lower side of the adapter board and part-contact pads 27 on the opposite side.

A further application of a protective mask 28 is then made on the two sides of the adapter board 8, the lower protective mask 28 covering the entire lower side of the board, whereas the upper mask leaves openings 29. These openings are filled with conducting material in a plating following thereafter.

It is pointed out that the plating may be carried out both electrolytically and in some other way.

The material plated in the openings 29 forms part-contact pads 30 located on top of the previously mentioned part-contact pads 27. Thus, this implies that the part-contact pads 27 and 30 (Fig 5) together form a contact pad generally denoted 31, the height of said contact pad suitably being in the order of twice as large as the height of the conducting paths 17, 18. It is pointed out that the plating 25 in the hole 22 extends substantially equally much outwardly from both sides of the adapter board 8 as the thickness of the conducting paths 17, 18.

On the contrary, the contact pad 31 is, in the example, twice as high as the conducting paths 17, 18.

The adapter board 8 is then processed such that the protective masks 23, 28 are removed. This leads to the configuration of Figs 6 and 7. The contact pad 31 comprises an outwardly protruding part-contact pad 30 on a conducting path portion 17. The part-contact pad 30 has an external surface 32 which is substantially planar and extends substantially parallel to the plane of the adapter board 8. The part-contact pad 30 comprises rather sharp corners 33, involving a risk of damaging the rubber mat 13.

In the next step illustrated in Figs 8 and 9 the adapter board is conceived to have been subjected to an etching operation, which has caused the contact pad 31 to have been chamfered or rounded at its extreme end as is indicated at 34. Accordingly, the sharp edge (90°) appearing at 33 in Fig 6 has been smoothed so that on application against the rubber mat 13 a more lenient contact is obtained.

The term etching used herein is to be understood as such a material-removing influence on the plated material on the adapter board 8 that a material removal occurs over the surface of the adapter board 8 so that after etching the different contact pads 31 will comprise substantially equal mutual relations as before the etching. Thus, expressed in other words the size of the contact pads 31 will be reduced by means of the etching. This means, accordingly, that the preceding plating must have been carried out to a larger size than the size finally intended after etching. More specifically, the area of the externally facing contact surfaces of the contact pads 31 as well as the thickness of the contact pads perpendicularly to the plane of the adapter board are reduced on etching.

It is pointed out that in the course of the etching forming the reason for the changes between the Figures 6 and 8, also the previously discussed copper layers 21 are removed.

The variant illustrated in Figs 10-16 will now be described. Also in this case a sheet 35 of an electrically conducting material is used as a starting material, such sheet having layers 36 of electrically conducting material, e.g. copper to a thickness of 5 µm, deposited on the sheet.

Next, a further conducting layer is plated on both sides of the sheet 35 as indicated in Fig 11. More specifically, copper may again be involved, for instance to a total thickness of 20+5 µm. In this plating, also the walls of the holes 38 is provided with a plated conducting material.

As indicated in Fig 12, an etching resist 39 is then applied on such places of the adapter board where the conducting, plated mateirial should remain. Thereafter, see Fig 13, the plated material not covered by the etching resist 39 is etched away so that only the portions present under the etching resist 39 remain as electrical conductors. The etching resist is then removed so that the situation according to Fig 14 is obtained. In Fig 15 the design also appearing from Fig 14 is illustrated in an enlarged scale. More specifically, the contact element comprises here a contact pad 40 on one side of the adapter board and a contact pad 41 on the other side. The contact pad 40 is here conceived to have an annular configuration, i.e. be formed by a ring of electrically conducting material extending about the through hole 42.

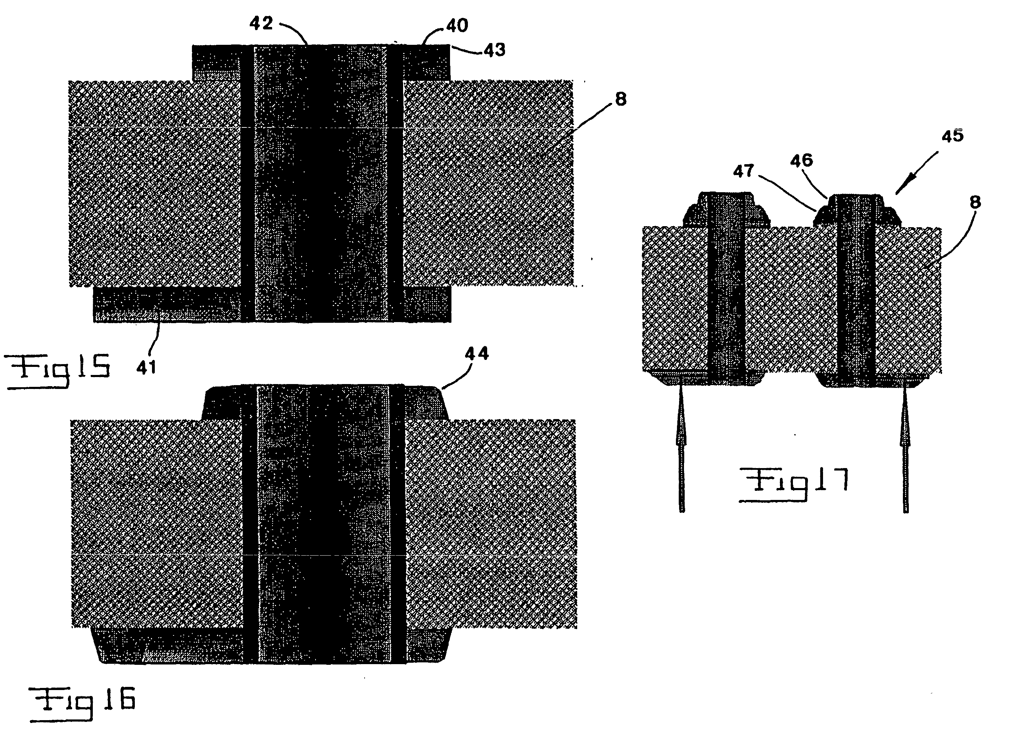

It is illustrated in Fig 16 that the device shown in Fig 15 has been subjected to micro etching. Also here the sharp corner at 43 in Fig 15 has been eliminated and instead a chamfering or rounding has been created at 44 so that on pressing of the adapter board against a rubber mat or similar of conducting material the mat is not subjected to the risk to be damaged by pressing of sharp-edged contact pads against the rubber mat. Finally, Fig 17 illustrates a variant similar to the one in Figs 15 and 16 in the sense that the plating on the wall of the hole through the adapter board 8 forms parts of a substantially annular contact pad 45. This consists of two part-contact pads 46, 47, which have been plated in two steps similar to what has been described in the embodiment according to Fig 2-9. The etching carried out has also here given rise to the peripherical edge of the contact pad being chamfered or rounded so as to obtain a minimum of wear/cutting on contact to the rubber mat 13.

It is evident that the invention described may be modified in several ways within the frame of the concept according to the invention. For example, it is pointed out that although it has been indicated for the sake of simplicity in Fig 1 and also in other figures that the adapter board 8 and the pattern board 1 are conceived to have contact pads on their external sides only, the reader is reminded that it is quite possible that the adapter board 8 as well as the pattern board 1 comprises electrically conducting paths provided between their respective external sides. Such electrically conducting paths provided internally in the respective boards are intended to be contacted via deeply bored holes adjacent to the conducting paths.

## Claims

1. A method for producing contact pads (10; 31; 40; 45) on adapter boards (8), comprising a plating treatment in order to apply i electrically conducting material on the board in correspondence to the desired contact pads, **characterized in that** the electrically conducting material at the contact pads is subjected to etching in order to provide chamfering or rounding of peripherical edges (33, 43) of the contact pads.

2. A method according to claim 1, **characterized in that** the plating treatment is carried out so that the contact pads obtain a larger size than the one finally intended, and that the reduction of the size to the intended size is carried out by means of said etching.

3. A method according to claim 2, **characterized in that** the plating treatment is carried out such that the contact pads on their outwardly facing contact surfaces obtain larger areas than the one intended finally and that the reduction of the areas to said finally intended is carried out by means of said etching.

4. A method according to claim 2 or 3, **characterized in that** the plating treatment is carried out such that the thickness of the contact pads is larger than the one finally intended and that the reduction of the thickness to the finally intended thickness is carried out by means of said etching.

5. An adapter board (8) for use in an apparatus for testing pattern boards provided with electrically conducting paths, the adapter board (8) comprising on a first side (9) first electrically conducting places (31; 40; 45) in the form of contact pads intended to be brought into contact with electrically conducting places on a pattern board to be tested and on a second side (11) second electrically conducting places intended to contact test-contact spots of the test apparatus, and **characterized in that** the contact pads (31; 40; 45) on the first side of the adapter board are provided with chamfered or rounded peripherical edges.

## Patentansprüche

1. Verfahren zur Herstellung von Kontaktplatten (10; 31; 40; 45) auf einer Adapterkarte (8), das eine Plattierungsbehandlung zum Aufbringen elektrisch leitenden Materials auf die Karte entsprechend den gewünschten Kontaktplatten umfasst, **dadurch gekennzeichnet, dass** das elektrisch leitende Material an den Kontaktplatten einem Ätzen unterzogen wird, um ein Abschrägen oder Abrunden von Umfangsrändern (33, 43) der Kontaktplatten vorzusehen.

2. Verfahren nach Anspruch 1, **dadurch gekennzeichnet, dass** die Plattierungsbehandlung so ausgeführt wird, dass die Kontaktplatten eine größere Größe erhalten als jene, die letztlich beabsichtigt ist, und dass die Reduzierung der Größe auf die beabsichtigte Größe mithilfe des Ätzens ausgeführt wird.

3. Verfahren nach Anspruch 2, **dadurch gekennzeichnet, dass** die Plattierungsbehandlung so ausgeführt wird, dass die Kontaktplatten auf ihren nach außen gerichteten. Kontaktoberflächen größere Bereiche erhalten als jener, der letztlich beabsichtigt ist, und dass die Reduzierung der Bereiche auf den letztlich beabsichtigten mithilfe des Ätzens ausgeführt wird.

4. Verfahren nach Anspruch 2 oder 3, **dadurch gekennzeichnet, dass** die Plattierungsbehandlung so ausgeführt wird, dass die Dicke der Kontaktplatten größer ist als diejenige, die letztlich beabsichtigt ist, und dass die Reduzierung der Dicke auf die letztlich beabsichtigte Dicke mithilfe des Ätzens ausgeführt wird.

5. Adapterkarte (8) zur Verwendung in einem Gerät zum Prüfen von Musterplatten, die mit elektrisch leitenden Bahnen versehen sind, wobei die Adapterkarte (8) auf einer ersten Seite (9) erste elektrisch leitende Stellen (31; 40; 45) in Form von Kontaktplatten, die in Kontakt mit elektrisch leitenden Stellen auf einer zu prüfenden Musterplatte gebracht werden sollen, und auf einer zweiten Seite (11) zweite elektrisch leitende Stellen umfasst, die Prüfkontaktpunkte des Testgeräts kontaktieren sollen, und **dadurch gekennzeichnet, dass** die Kontaktplatten (31; 40; 45) auf der ersten Seite der Adapterkarte mit abgeschrägten oder abgerundeten Umfangsrändern versehen sind.

## Revendications

1. Méthode de production de plots de contact (10, 31, 40, 45) sur des panneaux adaptateurs (8) comprenant un traitement de revêtement de façon à appliquer un matériau électriquement conducteur sur le panneau en correspondance avec les plots de contact désirés, **caractérisée en ce que** le matériau électriquement conducteur au niveau des plots de contact est soumis à une gravure de façon à chanfreiner ou à arrondir les arêtes périphériques (33, 43) des plots de contact.

2. Méthode selon la revendication 1, **caractérisée en ce que** le traitement de revêtement est réalisé de façon à ce que les plots de contact atteignent une taille plus grande que celle visée au final, et **en ce que** la réduction de leur taille à celle visée est menée au moyen de la dite gravure.

3. Méthode selon la revendication 2, **caractérisée en ce que** le traitement de revêtement est réalisé de façon à ce que les plots de contact sur leurs surfaces de contact faisant face à l'extérieur atteignent des surfaces plus grandes que celles visées au final et **en ce que** la réduction des surfaces à celle visée au final est menée au moyen de la dite gravure.

4. Méthode selon la revendication 2 ou 3, **caractérisée en ce que** le traitement est réalisé de façon à ce que l'épaisseur des plots de contact est plus grande que celle visée au final et **en ce que** la réduction de l'épaisseur à celle visée au final est menée au moyen de la dite gravure.

5. Un panneau adaptateur (8) destiné à être utilisé pour tester des panneaux en réseau équipés de voies électriquement conductrices, le panneau adaptateur (8) comprenant sur un premier côté (9) des premiers points électriquement conducteurs (31, 40, 45) sous la forme de plots de contact prévus destinés à être mis en contact avec les points électriquement conducteurs sur un tableau en réseau à tester et sur un second côté (11) des seconds points électriquement conducteurs destinés à être mis en contact avec des spots de test par contact de l'appareil de test, **caractérisé en ce que** les plots de contact (31, 40, 45) sont équipés de bords périphériques chanfreinés ou arrondis sur le premier côté du tableau adaptateur.
